# EUROPÄISCHE PATENTSCHRIFT

(11) **EP 2 845 219 B1**
(45) Veröffentlichungstag und Bekanntmachung des Hinweises auf die Patenterteilung: **17.07.2019**
(21) Anmeldenummer: 13719455.1
(22) Anmeldetag: 19.04.2013
(51) Int. Cl.: H01L 21/266, H01L 29/10, H01L 29/78

(54) **VERFAHREN ZUR HERSTELLUNG EINES PMOS-TRANSISTORS MIT NIEDRIGER SCHWELLSPANNUNG**
METHOD FOR MANUFACTURING A PMOS TRANSISTOR HAVING LOW THRESHOLD VOLTAGE
PROCÉDÉ DE FABRICATION D'UN TRANSISTOR PMOS À FAIBLE TENSION DE SEUIL

(30) Priorität: 02.05.2012 EP 12166404
(43) Veröffentlichungstag der Anmeldung: 11.03.2015
(73) Patentinhaber: Elmos Semiconductor Aktiengesellschaft, 44227 Dortmund (DE)
(72) Erfinder: ROTTER, Thomas, 44227 Dortmund (DE)
(74) Vertreter: dompatent von Kreisler Selting Werner - Partnerschaft von Patent- und Rechtsanwälten mbB
(86) Internationale Anmeldenummer: PCT/EP2013/058188
(87) Internationale Veröffentlichungsnummer: WO 2013/164210

(56) Entgegenhaltungen:
- EP-A1- 0 389 863
- DE-C1- 19 526 183
- GB-A- 2 320 802
- US-A- 4 927 772
- US-A1- 2010 176 449
- US-A1- 2010 289 032

## Beschreibung

Die Erfindung betrifft ein Verfahren zur Herstellung eines PMOS-Transistors mit niedriger Schwellspannung und insbesondere mit einer Schwellspannung um 0 Volt. Ein derartiger PMOS-Transistor wird mitunter auch als nativer PMOS-Transistor bezeichnet. Ferner betrifft die Erfindung einen hochvolt- und highside-fähigen PMOS-Transistor mit einer Schwellspannung um 0 Volt (z.B. zwischen -0,4 Volt und +0,5 Volt).

Für das Design von integrierten PMOS-Transistoren ist es mitunter von Bedeutung, dass die Schwellspannung der Transistoren durch den Herstellungsprozess einstellbar ist. Für bestimmte Anwendungsfälle, beispielsweise als Stromquelle, sind selbstleitende PMOS-Transistoren gefragt, die eine Schwellspannung um 0 Volt (z. B. im Bereich zwischen -0,4 Volt und 0 Volt oder gar geringfügig größer als 0 Volt, wie +0,5 Volt) aufweisen sollten. Darüber hinaus wird mitunter gefordert, dass Transistoren, also auch PMOS-Transistoren highside-fähig und für Hochvolt-Anwendungen ausgelegt sind.

Die Bereitstellung eines derartigen nativen PMOS-Transistors vereinfacht in vielen Applikationen das Design in der Weise, dass einerseits zu einem nativen NMOS komplementäre Schaltkonzepte realisiert werden können und andererseits notwendige Hilfspotentiale entfallen können.

Es ist bekannt, dass die Schwellspannung von MOS-Transistoren unter anderem durch die Dotierstoffkonzentration innerhalb des Kanalgebiets bestimmt wird. Die Dotierstoffkonzentration ergibt sich in der Regel durch Implantation von Dotierstoffen in ein Halbleitersubstrat und durch anschließendes thermisches Ausdiffundieren. Die Dotierstoff-Implantationsschritte eines Halbleiterbauelement-Herstellungsverfahrens sind im Vorhinein festgelegt. Dies gilt sowohl für die verwendeten Dosen und wie auch die Energien, mit der der Dotierstoff implantiert wird. Damit lässt sich gezielt eine bestimmte, aber leider nicht jede beliebige Schwellspannung eines MOS-Transistors einstellen. MOS-Transistoren mit technologisch einstellbarer Schwellspannung sind z.B. aus GB-A-2 320 802, DE-C-195 26 183, US-A-2010/289032, US-A-2010/ 176449, US-A-4 927 772 und EP-A-0 389 863 bekannt.

DE-C-195 26 183 beschreibt, wie innerhalb einer herkömmlichen CMOS-Technologie durch das Verfahren der lateralen Ausdiffusion sowohl für einen (lateralen) HV PMOS-Transistor (Fig. 1 der DE-C-195 26 183) wie auch einen vertikalen NMOS-Transistor (Fig. 2 der DE-C-195 26 183) jeweils eine drainseitige Driftstrecke mit geeigneter niedriger Dotierung zur verbesserten Spannungsaufnahme generiert werden kann.

Das Verfahren der lateralen Ausdiffusion bleibt aber in beiden Fällen auf den Bereich der drainseitigen Driftstrecke beschränkt. In keinem der dargestellten Fälle unterliegt der jeweilige MOS-Steuerkopfbereich einer bewussten lateralen Verarmung.

Damit liegt im Fall der dargestellten HV PMOS-Transistoren die Schwellspannung der realisierten Transistoren im für Transistoren vom Anreicherungstyp üblichen Bereich von -0,5 Volt bis -1,5 Volt, also z.B. typischerweise bei etwa -0,7 Volt.

Der Erfindung liegt die Aufgabe zu Grunde, ein Verfahren zur Herstellung eines PMOS-Transistors mit niedriger Schwellspannung anzugeben.

Die obige Aufgabe wird erfindungsgemäß gelöst durch ein Verfahren zur Herstellung eines PMOS-Transistors mit niedriger Schwellspannung, das die Schritte des Anspruchs 1 umfasst.

Zur Lösung dieser Aufgabe wird mit der Erfindung ein Verfahren zur Herstellung eines PMOS-Transistors mit niedriger Schwellspannung nach Anspruch vorgeschlagen.

Einzelne Ausgestaltungen des erfindungsgemäßen Verfahrens sind Gegenstand der Unteransprüche.

Der erfindungsgemäß hergestellte PMOS-Transistor ist in einem p-dotierten Halbleitersubstrat (beispielsweise Silizium) ausgebildet, das eine Oberseite aufweist, in der ein Aktivgebiet ausgebildet ist. Das Aktivgebiet wird definiert durch ein n-dotiertes Wannengebiet, das in dem Halbleitersubstrat ausgebildet ist und sich bis zur Oberseite des Halbleitersubstrats erstreckt. Innerhalb des Wannengebietes sind p-dotierte Source- und Drain-Anschlussgebiete ausgebildet, wobei sich zwischen diesen beiden Anschlussgebieten das eigentliche Kanalgebiet befindet.

Erfindungsgemäß weist nun das Kanalgebiet ein Dotierstoffprofil auf, das - in Erstreckung zwischen den Source- und den Drain-Anschlussgebieten betrachtet - entweder eine im Wesentlichen homogene oder eine uneinheitliche Dotierstoffkonzentration aufweist. Dieses Dotierstoffprofil resultiert aus der thermischen Diffusion von Ionen mindestens eines Dotierstoffs einer Ionenimplantationszone mit Ausmaskierungen. Die Ausmaskierung umfasst mindestens einen Ausmaskierungsbereich, der sich zumindest teilweise innerhalb des Kanalgebiets erstreckt. Über dem Kanalgebiet befindet sich eine Gate-Isolationsschicht mit einer Gate-Elektrode.

Durch die Ausmaskierung der Ionenimplantationszone kann die Dotierstoffkonzentration in lateraler Erstreckung, d. h. in Erstreckung der Oberseite des Halbleitersubstrats beeinflusst werden (Variation of Lateral Doping - VLD - siehe auch EP-B-0 176 778). Innerhalb der ausmaskierten Bereiche werden also keine Ionen bzw. keine Dotierstoffe implantiert. Bei der thermischen Diffusion dringen dann die benachbart zu den Ausmaskierungsbereichen implantierten Ionen bzw. Dotierstoffe in die von Ionen freien Ausmaskierungsbereiche hinein. Insgesamt kann damit die Dotierstoffkonzentration der Größe und dem Gradienten nach beeinflusst werden, was erfindungsgemäß für die Einstellung und Bestimmung der Schwellspannung eines PMOS-Transistors genutzt wird, damit dieser eine Schwellspannung um 0 Volt, d. h. eine niedrige Schwellspannung aufweist.

Die flächenmäßige Erstreckung der Ausmaskierung kann in Abhängigkeit von der Diffusionslänge des bzw. der Dotierstoffe gewählt werden. Bei Ausmaskierungsbereichen, die in einer der beiden Flächendimensionen kleiner als die Diffusionslänge sind, gelangt also durch die thermische Diffusion der Dotierstoff bzw. gelangen die Dotierstoffe in den gesamten Ausmaskierungsbereich hinein, wobei dies mit einem Gradienten erfolgen kann.

Unter Verwendung des erfindungsgemäßen Ansatzes lassen sich Kanalgebiete für PMOS-Transistoren mit einem im Wesentlichen homogenen Dotierstoffprofil beispielsweise dadurch erzeugen, dass die Ausmaskierung der Ionenimplantationszone gleich große und gleich verteilte Ausmaskierungsbereiche aufweist. Wenn die Dichte und/oder Größe der Ausmaskierungsbereiche variiert wird, so lassen sich spezielle uneinheitliche Dotierstoffkonzentrationen realisieren. Auch ist es möglich, durch überlappende Anordnung eines Ausmaskierungsbereichs mit dem späteren Kanalgebiet und durch Anordnung dazu benachbarter Ausmaskierungsbereiche auf die Dotierstoffkonzentration innerhalb des Kanalgebiets Einfluss zu nehmen, was weiter unten noch beschrieben werden wird.

In vorteilhafter Weiterbildung der Erfindung ist vorgesehen, dass die Ausmaskierung der Ionenimplantationszone einen ersten Ausmaskierungsbereich aufweist, der sich innerhalb des Kanalgebiets und allseitig über dieses hinaus erstreckt und einen source-seitigen ersten sowie einen drain-seitigen zweiten Rand und zu diesen quer verlaufende dritte und vierte Ränder aufweist, wobei der source-seitige Rand des ersten Ausmaskierungsbereichs vom source-seitigen Ende des Kanalgebiets und der drain-seitige Rand des ersten Ausmaskierungsbereichs von dem drain-seitigen Ende des Kanalgebiets gleiche oder unterschiedliche Abstände aufweist. Hierbei kann in weiterer vorteilhafter Ausgestaltung der Erfindung vorgesehen sein, dass einer der Abstände kleiner als eine Diffusionslänge seines Dotierstoffs und der andere größer als die Diffusionslänge ist und/oder dass die dritten und vierten Ränder des ersten Ausmaskierungsbereichs einen Abstand von den ihnen jeweils gegenüberliegenden Enden des Kanalgebiets aufweisen, der größer ist als die Diffusionslänge.

Zusätzlich zu der zuvor beschriebenen Weiterbildung der Erfindung kann in vorteilhafter Weise noch vorgesehen sein, dass die Ausmaskierung der Ionenimplantationszone einen zweiten oder auch weitere Ausmaskierungsbereiche aufweist, der/die in einem Abstand, welcher insbesondere kleiner als die Diffusionslänge ist, zum source-seitigen oder drain-seitigen Rand des ersten Ausmaskierungsbereichs angeordnet ist/sind.

Wie bereits oben erwähnt, ist eine Variante der Erfindung darin zu sehen, dass die Ausmaskierung der Ionenimplantationszone mehrere gleich große und/oder unterschiedlich große Ausmaskierungsbereiche aufweist, die innerhalb des Kanalgebiets und gegebenenfalls außerhalb dieses angeordnet sind.

Gemäß einem weiteren Aspekt des erfindungsgemäß hergestellten PMOS-Transistors ist vorgesehen, dass zwischen benachbarten Ausmaskierungsbereichen der Ionenimplantationszone in die Oberfläche des Halbleitersubstrats eingebrachte Oberflächenvertiefungen angeordnet sind und dass die Oberflächenvertiefungen mit einem elektrisch isolierenden und/oder halbleitenden Füllmaterial aufgefüllt sind, wobei das Füllmaterial ein oxidiertes Halbleitermaterial sein kann. Insbesondere handelt es sich bei dem Halbleitersubstrat um Silizium, wobei dann das Füllmaterial ein Siliziumoxid sein kann.

Bei dem erfindungsgemäßen Verfahren können mit Vorteil noch die Schritte des Entfernens von Bereichen des Halbleitersubstrats an dessen Oberseite, welche in der Nähe der Aussparungsränder enden bis zu einer vorgebbaren Tiefe zur Ausbildung von Oberflächenvertiefungen, insbesondere durch lokales Ätzen, und des Auffüllens der Oberflächenvertiefungen des Halbleitersubstrats, insbesondere durch Abscheiden, mit einem elektrisch isolierenden und/oder einem halbleitenden Füllmaterial vorgesehen sein, wobei optional das Halbleitersubstrat nach dem Auffüllen der Oberflächenvertiefungen an seiner Oberseite chemisch und/oder mechanisch planarisiert wird. Hierbei ist es möglich, dass die unterschiedlichen n-Dotierstoffe unterschiedlich tief in das Halbleitersubstrat eindringen, wobei vorgesehen sein kann, dass der weniger tief eindringende n-Dotierstoff nach einem sich an die Mehrfach-Implantation anschließenden thermischen Behandlungsschritt in dem Halbleitersubstrat weniger weit ausdiffundiert als der tiefer eindringende n-Dotierstoff.

Bei einer weiteren Ausgestaltung der Erfindung werden durch die Oberflächenvertiefungen diejenigen Bereiche des Halbleitersubstrats, die in ihrer Oberflächendotierstoffkonzentration erhöht sind, ausgehoben und dadurch werden deren Oberflächendotierstoffkonzentration für die Bestimmung der Schwellspannung nicht wirksam.

Um den PMOS-Transistor gemäß der Erfindung bzw. den nach dem erfindungsgemäßen Verfahren hergestellten PMOS-Transistor hochvoltfähig zu gestalten, kann vorgesehen sein, dass im Drain-Anschlussgebiet und/oder zwischen dem Drain-Anschlussgebiet und dem Kanalgebiet zur Erhöhung der Spannungsfestigkeit eine Drift- bzw. Extensionszone angeordnet ist bzw. ausgebildet wird.

Die Erfindung wird nachfolgend anhand mehrerer Ausführungsbeispiele und unter Bezugnahme auf die Zeichnung näher erläutert. Im Einzelnen zeigen dabei:
- Fig. 1: eine schematische Darstellung eines PMOS-Transistors im Querschnitt, wobei lediglich die für die Erfindung wesentlichen Komponenten des PMOS-Transistors dargestellt sind,
- Fig. 2: eine teilweise Draufsicht auf die Oberseite des Halbleitersubstrats im Aktivgebietsbereich und um diesen herum,
- Fig. 3: eine Darstellung ähnlich der gemäß Fig. 2, wobei die Ausmaskierung für die Ionenimplantation gemäß einem ersten Ausführungsbeispiel dargestellt ist,
- Fig. 4: eine Darstellung ähnlich der gemäß Fig. 2, wobei die Ausmaskierung für die Ionenimplantation gemäß einem zweiten Ausführungsbeispiel dargestellt ist,
- Fig. 5: eine Darstellung ähnlich der gemäß Fig. 2, wobei die Ausmaskierung für die Ionenimplantation gemäß einem dritten Ausführungsbeispiel dargestellt ist,
- Fig. 6: eine schematische Darstellung der Implantation zweier verschiedener Dotierstoffe, wobei ein erster Dotierstoff weniger tief in das Halbleitersubstrat implantiert worden ist als ein zweiter Dotierstoff, wobei durch die unterschiedlich langen Pfeile angedeutet ist, dass die Diffusionslänge des ersten Dotierstoffs geringer ist als die Diffusionslänge des zweiten Dotierstoffs,
- Fig. 7: die Dotierstoffkonzentration nach der Ausdiffusion im Anschluss an die Implantation gemäß Fig. 6,
- Fig. 8: schematisch die Entfernung von oberflächennahen Bereichen, in denen sich eine relativ hohe Konzentration des ersten implantierten Dotierstoffs befindet, und die Ausfüllung dieser entfernten Bereiche durch ein elektrisch isolierendes Material,
- Fig. 9: eine Draufsicht auf die Oberseite des Halbleitersubstrats im Bereich des Aktivgebiets und um dieses herum, wobei die Ausmaskierung gemäß Variante nach Fig. 4 mit den in den Fign. 6 bis 8 erläuterten Schritten kombiniert ist,
- Fig. 10: eine Draufsicht auf die Oberseite des Halbleitersubstrats im Bereich des Aktivgebiets und um dieses herum, wobei die Ausmaskierung gemäß Variante nach Fig. 3 mit den in den Fign. 6 bis 8 erläuterten Schritten kombiniert ist,
- Fig. 11: eine schematische Draufsicht auf die Oberseite des Halbleitersubstrats im Bereich des Aktivgebiets und um dieses herum, wobei nunmehr angedeutet ist, dass sich die Dotierstoffkonzentration vom Source-Gebiet zum Drain-Gebiet verringert, also uneinheitlich ist,
- Fig. 12: eine Draufsicht auf die Oberseite des Halbleitersubstrats (teilweise) im Bereich des Aktivgebiets und um dieses herum, wobei eine erste Variante einer Ausmaskierung zur Erzeugung des Dotierstoffprofils gemäß Fig. 11 gezeigt ist,
- Fig. 13: eine Draufsicht auf die Oberseite des Halbleitersubstrats (teilweise) im Bereich des Aktivgebiets und um dieses herum, wobei eine zweite Variante einer Ausmaskierung zur Erzeugung des Dotierstoffprofils gemäß Fig. 11 gezeigt ist,
- Fig. 14: eine Draufsicht auf die Oberseite des Halbleitersubstrats (teilweise) im Bereich des Aktivgebiets und um dieses herum, wobei eine dritte Variante einer Ausmaskierung zur Erzeugung des Dotierstoffprofils gemäß Fig. 11 gezeigt ist,
- Fign. 15 und 16: jeweils einen Querschnitt durch alternativ ausgebildete PMOS-Transistoren mit Driftstrecke bzw. Drain-Extension zur Erzielung der Hochvoltfähigkeit und
- Fig. 17: eine Übersicht über die für die Erfindung wesentlichen Verfahrensschritte bei der Herstellung eines PMOS-Transistors.

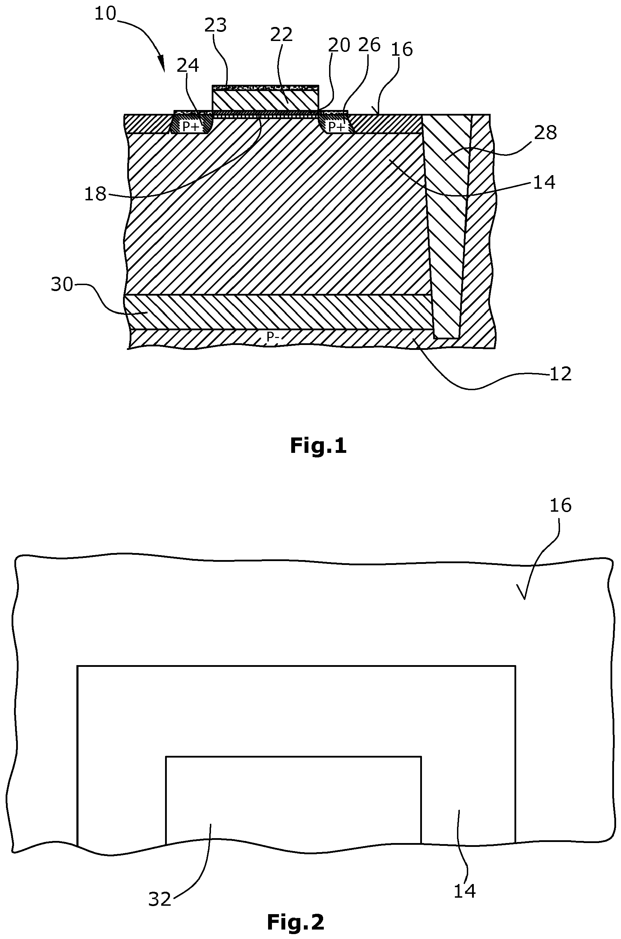

Fig. 1 zeigt schematisch und im Querschnitt die für die Erfindung wesentlichen Komponenten eines PMOS-Transistors 10, der in diesem Ausführungsbeispiel in einem schwach p-dotierten Silizium-Halbleitersubstrat 12 ausgebildet ist. In dem Halbleitersubstrat 12 ist ein n-dotiertes Wannengebiet 14 ausgebildet, das durch eine Ionenimplantation und durch thermische Ausdiffusion entstanden ist. Die Ionenimplantation erfolgt durch die Oberseite 16 des Halbleitersubstrats 12 hindurch, wie dies an sich üblich und bekannt ist.

Innerhalb des n-Wannengebiets 14, und zwar an dessen Oberseite 16, ist darüber hinaus das eigentliche Kanalgebiet 18 des PMOS-Transistors 10 ausgebildet. Dieses Kanalgebiet 18 entsteht als Folge der Ionenimplantation und der thermischen Ausdiffusion. Auf dem Kanalgebiet 18 befindet sich eine Gate-Oxidschicht 20 mit einer Gate-Elektrode 22 und eventuell eine metallische Verstärkung 23 auf dieser Schicht. Seitlich des Kanalgebiets 18 befinden sich das Source-Anschlussgebiet 24 und das Drain-Anschlussgebiet 26, wie dies ebenfalls grundsätzlich bekannt ist. Ferner erstreckt sich um den Transistor 10 herum eine laterale Isolation. Der gesamte Transistorbereich kann zusätzlich durch eine dielektrische Isolation - beispielsweise einen sogenannten deep trench (DTI) 28 gegenüber benachbarten Strukturen des Halbleitersubstrats 12 isoliert sein. Desweiteren kann in Epitaxie-basierten Technologien vielfach auch eine verstärkte Isolation 30 zum Grundsubstrat 12 vorgesehen sein (beispielsweise durch einen n buried layer - NBL), was dazu führt, dass der Transistor 10 auch auf stark vom Potential des Halbleitersubstrats 12 entrückten Potentialen betrieben werden kann (verstärkte Highside-Fähigkeit).

Fig. 2 zeigt eine Draufsicht auf die Oberseite 16 des Halbleitersubstrats 12 im Bereich des Transistors 10. Zu erkennen sind das eigentliche Aktivgebiet 32 des Transistors und der dieses Gebiet umgebende Bereich des n-Wannengebiets 14. Außerhalb des n-Wannengebiets 14 ist der umgebende Bereich des Halbleitersubstrats 12 zu erkennen.

Erfindungsgemäß weist das n-Wannengebiet 14 im Bereich um das Aktivgebiet 32 sowie innerhalb dieses Aktivgebiets 32 eine Dotierstoffkonzentration auf, die dazu führt, dass der PMOS-Transistor eine niedrige Schwellspannung im Bereich von 0 Volt aufweist. Dies gelingt erfindungsgemäß, obwohl bei der Ionenimplantation mit unveränderten Dosen und Energien gearbeitet wird, die ohne besondere Maßnahmen zu einer höheren Dotierstoffkonzentration als erfindungsgemäß im Wannengebiet 14 vorgesehen und damit auch zu betragsmäßig höheren Schwellspannung führen würden.

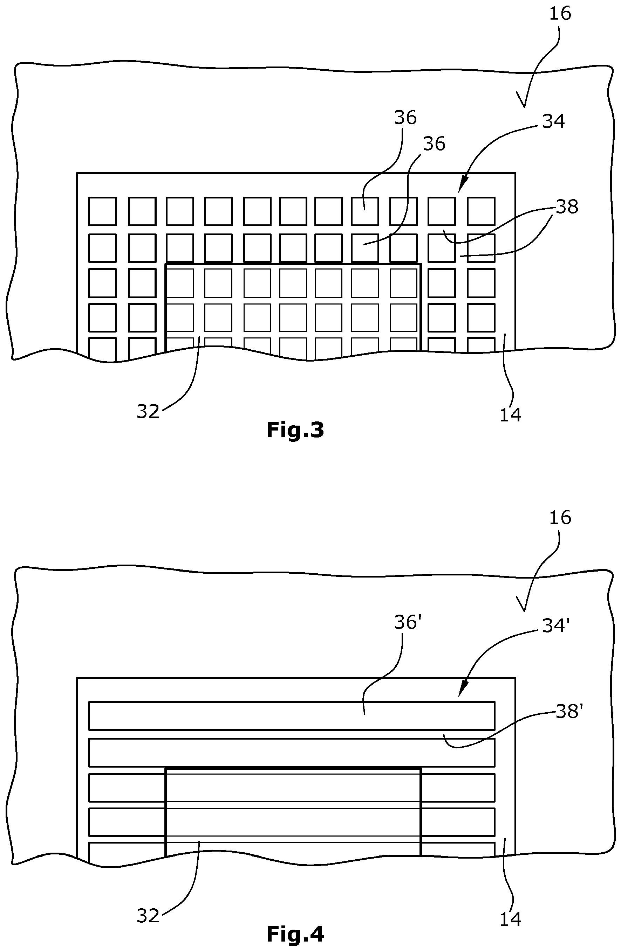

Anhand der Fign. 3 bis 5 wird nachfolgend darauf eingegangen, wie trotz erhöhter Implantationsdosis innerhalb des Wannengebiets 14 bzw. an dessen Oberseite nach der thermischen Ausdiffusion eine gegenüber dem anderen Bereich verringerte Dotierstoffkonzentration entsteht.

Gemäß Fig. 3 wird zu diesem Zweck vor der Ionenimplantation das n-Wannengebiet 14 ausmaskiert, und zwar mit einer Fotolack-Ausmaskierung 34. Diese Ausmaskierung 34 umfasst eine Vielzahl von gleichverteilten (Ausmaskierungs-)Bereichen 36, innerhalb derer sich Fotolack befindet. Anstelle eines Fotolacks kann auch ein anderes die Implantation verhinderndes Material verwendet werden. Durch die Ausmaskierung 34 gelangt nun also die Ionenimplantation lediglich in die in diesem Beispiel gitterförmigen Zwischenbereiche 38 hindurch und in das zu formende n-Wannengebiet 14 hinein. Bei der anschließenden thermischen Ausdiffusion bewegen sich die Dotierstoffe nun auch in die Bereiche, die zuvor durch die Ausmaskierungsbereiche 36 abgedeckt waren, hinein. Dadurch reduziert sich insgesamt die Dotierstoffkonzentration im n-Wannengebiet 14 im Vergleich zu einem n-Wannengebiet, welches in einem durchgehenden Teilgebiet geformt wurde, an der Oberseite 16 des Substrats 12.

In Fig. 4 ist ein Beispiel für eine alternativ ausgebildete Ausmaskierung 34' gezeigt. Dort sind die mit dem Implantationsblockierungsmaterial versehenen Ausmaskierungsbereiche 36' als langgestreckte Streifen ausgebildet, wodurch ebenfalls längliche Zwischenbereiche 38' entstehen, in denen die Ionenimplantation erfolgt.

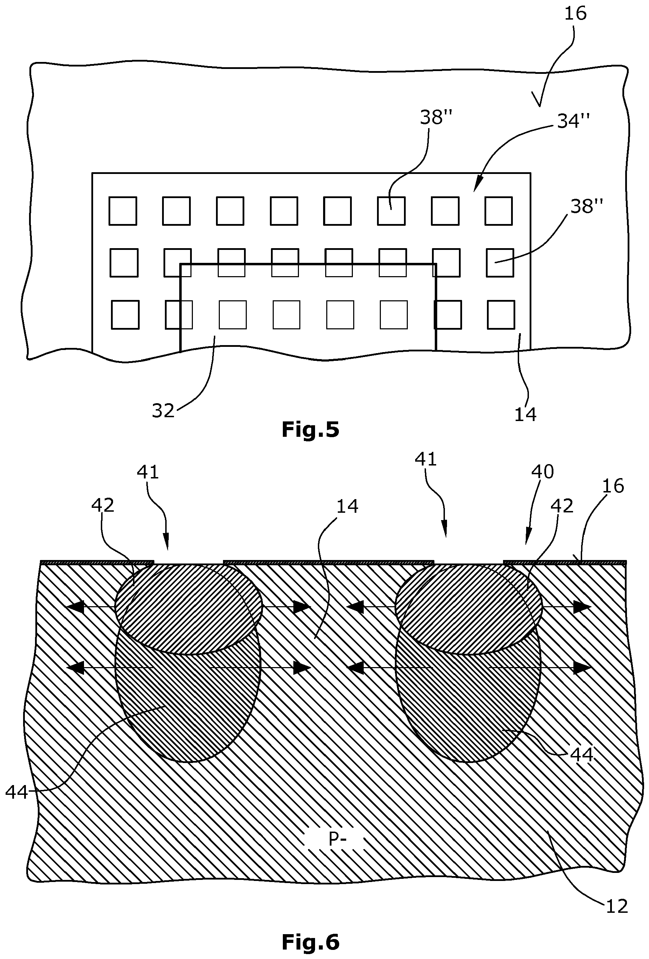

Schließlich zeigt Fig. 5 ein Beispiel, bei dem die Ausmaskierung 34" invers zum Ausführungsbeispiel gemäß Fig. 3 ausgebildet ist. Zu erkennen ist, dass die implantierten Bereiche 38" nunmehr als einzelne allseitig abgeschlossene Felder bzw. Inseln ausgebildet sind.

Die zuvor beschriebenen Ausführungsbeispiele zeigen einen Weg auf, wie man konstruktiv auf das sich nach einer Ionenimplantation und thermischen Ausdiffusion ergebende Dotierstoffprofil Einfluss nehmen kann, um dies zu verringern, obwohl die verwendeten Dosen und Energien für die Ionenimplantation zu einer weit höheren Dotierstoffkonzentration führen würden.

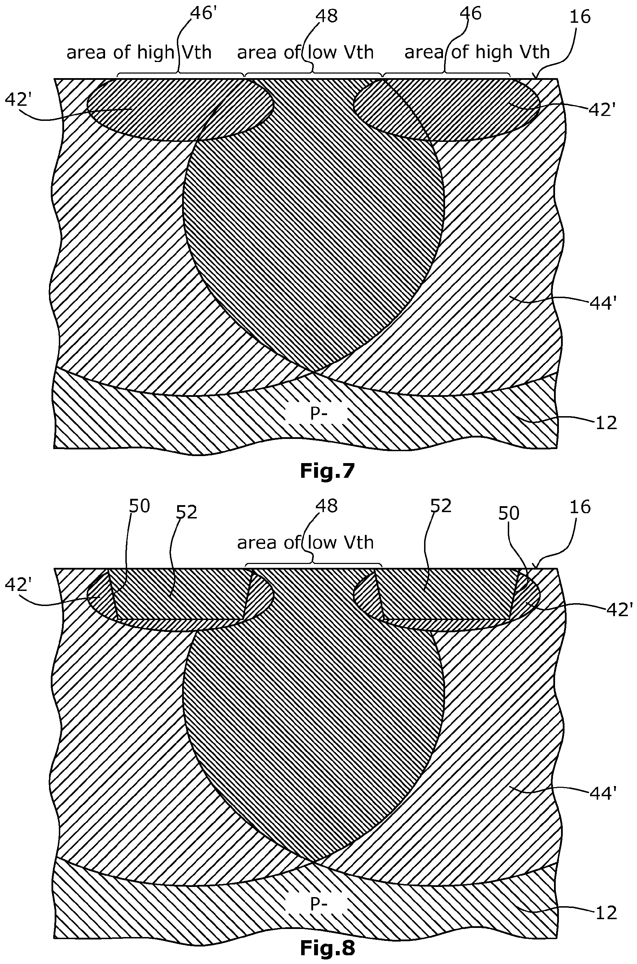

Diese Vorgehensweise kann erfindungsgemäß auch dann eingesetzt werden, wenn als Ionenimplantation eine zwei- oder mehrstufige Implantation verwendet wird. Dies ist in Fig. 6 angedeutet. In die Oberseite 16 des Halbleitersubstrats 12 wird durch eine Ausmaskierung 40 ein zweistufiger Ionenimplantationsschritt angewendet. Durch diese beiden Ionenimplantationsschritte werden durch freiliegende Bereiche 41 der Ausmaskierung 40 zwei Dotierstoffe in zwei Teilgebiete 42 und 44 eingebracht, wobei der Dotierstoff des Teilgebiets 44 tiefer in das Halbleitersubstrat 12 eindringt als der Dotierstoff des Teilgebiets 42. In der nachfolgenden Ausdiffusion weist der (erste) Dotierstoff des Teilgebiets 42 dabei eine geringere Beweglichkeit, d. h. eine geringere Diffusionslänge auf, als der zweite Dotierstoff des Teilgebiets 44. Nach der thermischen Ausdiffusion ergibt sich eine schematisch dargestellte Situation gemäß Fig. 7. Während das Teilgebiet 42' des ersten Dotierstoffs sich nur in geringem Maße ausgebreitet hat, breitet sich das Teilgebiet 44' des zweiten Dotierstoffes weit stärker aus, so dass sich die ursprünglich getrennten Teilgebiete 44 nun auch überlappen können. Längs der Oberseite 16 des Halbleitersubstrats 12 bilden sich daher Bereiche höherer Dotierstoffkonzentration und Bereiche niedrigerer Dotierstoffkonzentration aus. Den Bereichen höherer Oberflächen-Dotierstoffkonzentration 46 ist allgemein eine höhere Schwellspannung als den Bereichen 48 niedrigerer Oberflächen-Dotierstoffkonzentration zuzuordnen. Zusätzlich können in einem nächsten Schritt nun aus der Oberseite 16 des Halbleitersubstrats 12 Bereiche herausgenommen (siehe die Oberflächenvertiefungen 50) werden, die dann mit elektrisch nicht leitendem Füllmaterial 52 wie beispielsweise Siliziumoxid ausgefüllt werden.

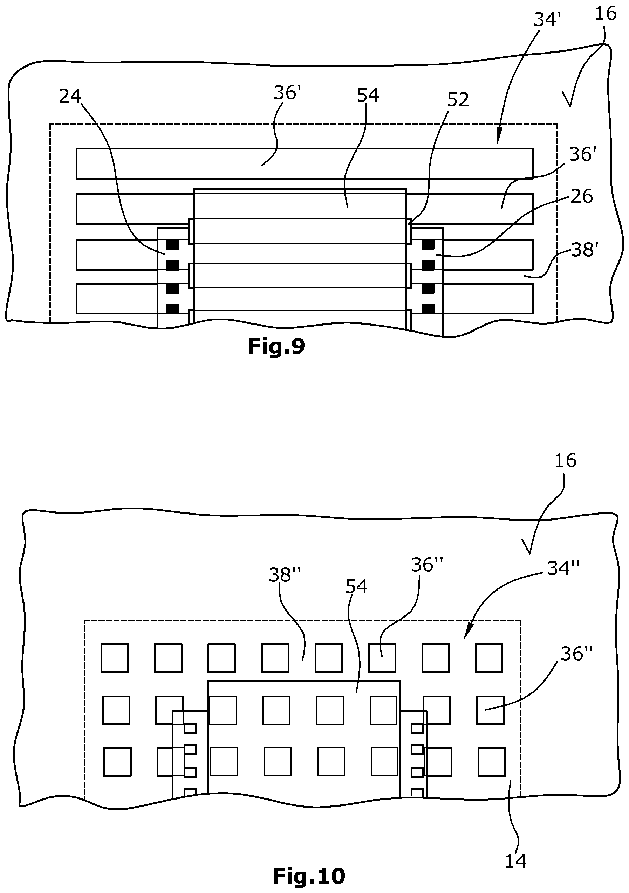

Eine Draufsicht auf die Oberseite 16 des Halbleitersubstrats 12 nach Bearbeitung des Halbleitersubstrats gemäß den Fign. 6 bis 8 ist in Fig. 9 gezeigt. In Fig. 9 sind darüber hinaus das Gate 54 des MOS-Transistors und die Source- und Drain-Anschlussgebiete 24,26 angedeutet.

Fig. 10 zeigt eine ähnliche Situation wie in Fig. 9, wobei jedoch für die Ausmaskierung gilt, dass diese gemäß Fig. 5 ausgebildet ist. Demgegenüber handelt es sich bei der Ausmaskierung gemäß Fig. 9 um diejenige, die im Zusammenhang mit Fig. 4 beschrieben ist.

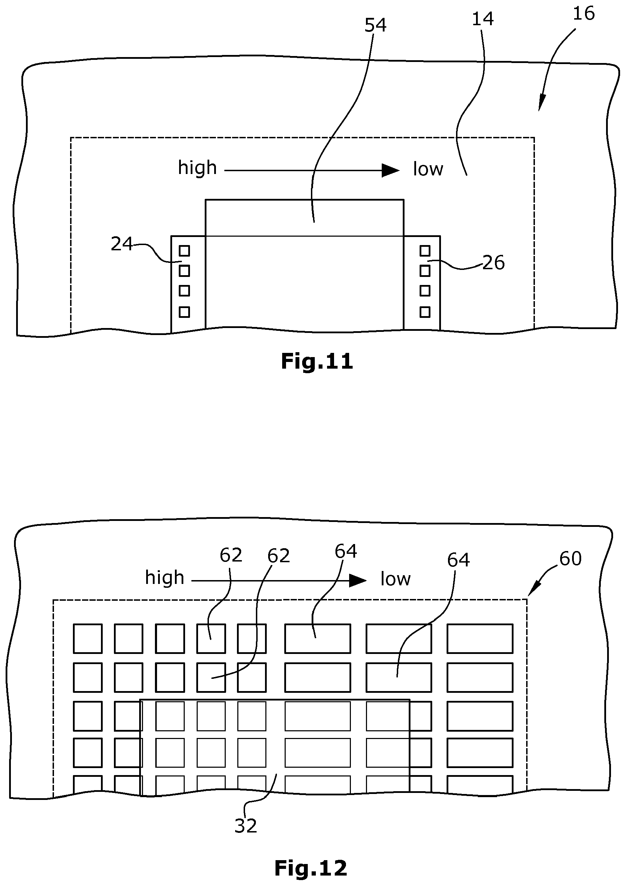

Anhand von Fig. 11 wird nachfolgend auf eine weitere alternative Ausgestaltung des erfindungsgemäßen Konzeptes eingegangen.

Gemäß Fig. 11 weist das n-Wannengebiet 14 einen Dotierstoffgradienten zwischen dem Source-Anschlussgebiet 24 und dem Drain-Anschlussgebiet 26 auf. Dieses Dotierstoffprofil entsteht beispielsweise durch eine Ausmaskierung 60, wie sie in Fig. 12 gezeigt ist. Zu erkennen sind die ausmaskierten Bereiche 62 und 64 unterschiedlicher Größe, wodurch die nach der Ionenimplantation nicht mit Ionen versehenen Bereiche des Aktivgebiets 32 unterschiedlich groß sind und zum Drain-Anschlussgebiet 26 hin größer werden. Dadurch verringert sich nach der Ausdiffusion zum Drain-Anschlussgebiet 26 hin die Dotierstoffkonzentration.

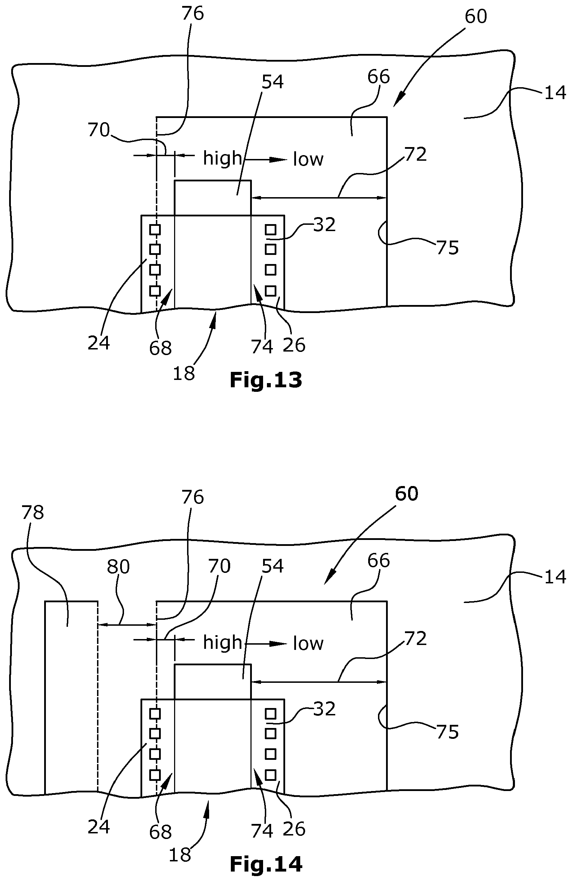

In Fig. 13 ist eine alternative Ausgestaltung der Erzeugung eines Dotierstoffgradienten zwischen dem Source-Anschlussgebiet 24 und dem Drain-Anschlussgebiet 26 gezeigt. Das gesamte Aktivgebiet 32 mit umgebenem Bereich ist durch einen Ausmaskierungsbereich 66 nach der Ionenimplantation frei von Ionen. Benachbart zum Source-seitigen Ende 68 des Gate 54 endet der Ausmaskierungsbereich 66 im Abstand 70. Bei der Ausgestaltung gemäß Fig. 13 ist der Abstand 70 ist deutlich kleiner als der Abstand 72 zwischen dem Drain-seitigen Ende 74 des Gate 54 und dem Begrenzungsrand 75 des Ausmaskierungsbereichs 66. Der Abstand 72 kann größer als die Diffusionslänge des Dotierstoffs bzw. der Dotierstoffe sein. Somit dringen in das Kanalgebiet 18 unterhalb des Gate 54 lediglich Dotierstoffe bzw. lediglich ein Dotierstoff vorzugsweise von dem dem Drain-seitigen Ende 74 des Gate 54 gegenüberliegenden Rand 76 des Ausmaskierungsbereichs 66, während die vom Begrenzungsrand 75 ausgehende Ausdiffusion im wesentlichen vernachlässigt werden kann. Insgesamt stellt sich damit ein Gradient der Dotierstoffkonzentration unterhalb des Gate 54 und im Kanalgebiet 18 ein, wobei die Dotierstoffkonzentration zum späteren Drain-Anschlussgebiet 26 hin immer weiter abnimmt.

Ist der Abstand 70 deutlich grösser als der Abstand 72 gewählt, so drehen sich die Verhältnisse um und die Dotierstoffkonzentration nimmt ausgehend vom späteren Drain-Anschlussgebiet 26 zum Source-Anschlussgebiet 24 hin ab.

Sind beide Abstände 70 und 72 in etwa gleich gewählt und insbesondere auch kleiner als die Diffusionslänge des Dotierstoffs bzw. der Dotierstoffe, so erhält man eine Situation, in welcher sowohl vom späteren Source-Anschlussgebiet 24 wie auch vom Drain-Anschlussgebiet 26 eine Ausdiffusion von den Ausmaskierungsrändern 76 bzw. 75, d.h. von beiden Seiten und im gleichen Maß in das Kanalgebiet 18 hinein stattfindet. Die resultierende Dotierstoffkonzentration nimmt unterhalb des Gate 54 dabei in Richtung von einem der beiden Anschlussgebiete 24 oder 26 kommend zunächst ab, erreicht in der Kanalmitte ein Minimum, und nimmt dann wieder in Richtung zum anderem Anschlussgebiet 26 oder 24 im gleichen Maße zu, wie es zuvor abgenommen hat.

Ergänzend zu den obigen Betrachtungen kann bei zweckmäßiger Ausgestaltung des Transistors einer der beiden Abstände 70,72 oder gar beide verschwinden oder sogar negativ werden, so dass das Kanalgebiet 18 zumindest an einem der beiden Anschlussgebiete 24,26 die freiliegende, nicht durch den Ausmaskierungsbereich 66 erfassten Oberfläche 16 berührt oder gar überlappt.

Durch die in Fig. 14 gezeigte Maßnahme lässt sich die Dotierstoffkonzentration im Bereich des Source-seitigen Endes 68 des Gate 54 sowie unterhalb dieses Gates weiter verringern. Zusätzlich zum Ausmaskierungsbereich 66 wird hierzu ein weiterer Ausmaskierungsbereich 78 genutzt, dessen Abstand 80 zum Ausmaskierungsbereich 66 im Wesentlichen kleiner als die Diffusionslänge ist. Hierdurch wird erreicht, dass der Dotierstoff aus dem Bereich zwischen den beiden Ausmaskierungsbereichen 66 und 78 auch in den zuvor durch den Ausmaskierungsbereich 78 verdeckten Bereich ausdiffundiert, wodurch die Dotierstoffmenge, die nun in Richtung auf das Kanalgebiet 18 ausdiffundieren kann, weiter verringert wird.

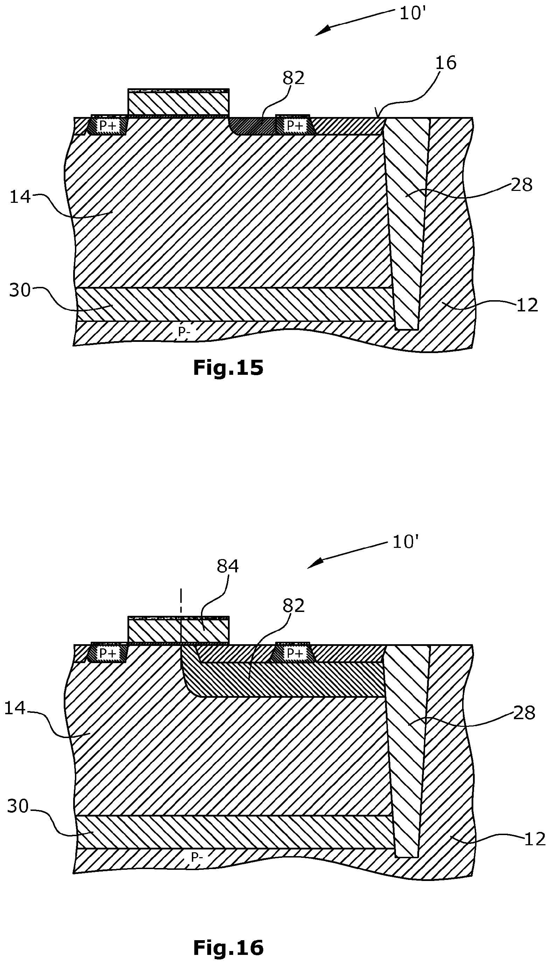

Fign. 15 und 16 zeigen schließlich zwei Varianten, bei welchen der PMOS-Transistor 10' mit verringerter Schwellspannung asymmetrisch und sperrspannungsfester ausgebildet ist. Hierzu weisen beide Varianten ein Drain-Extensionsgebiet 82 und die Variante in Fig. 16 zusätzlich eine Feldplatte 84 auf, wie dies an sich üblich ist, um eine Driftstrecke zum Abbau von erhöhten Sperrspannungen zwischen Drain- und Source des Transistors 10' anzubieten. Dieses Konzept der erweiterten Hochvolt-Fähigkeit eines PMOS-Transistors lässt sich also mit dem erfindungsgemäßen Konzept der Ausmaskierung bei der Ionenimplantation zur Beeinflussung der Schwellspannung des PMOS-Transistors 10' kombinieren.

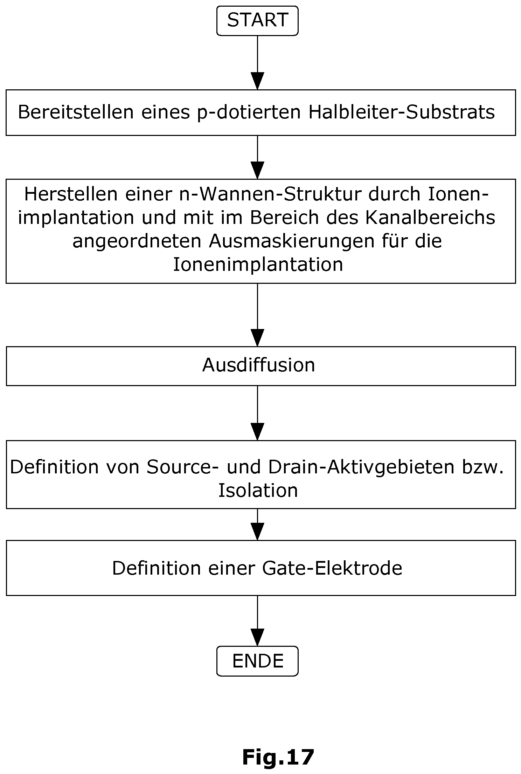

Abschließend sei noch auf Fig. 17 verwiesen, welche die wesentlichen Verfahrensschritte zur Herstellung eines PMOS-Transistors gemäß einem erfindungsgemäßen Ausführungsbeispiel wiedergibt.

## Patentansprüche

1. Verfahren zur Herstellung eines PMOS-Transistors mit niedriger Schwellspannung zwischen -0,4 Volt und +0,5 Volt, mit den folgenden Schritten:
- Bereitstellen eines p-dotierten Halbleitersubstrats (12) mit einer Oberseite (16),
- Erzeugen eines n-dotierten Wannengebiets (14) durch Implantation eines n-Dotierstoffs durch die Oberseite (16) des Halbleitersubstrats (12) in dieses hinein,
- Definieren eines Kanalgebiet (18) an der Oberseite (16) des Halbleitersubstrats (12) innerhalb des Wannengebiets (14),
- Maskieren des Kanalgebiets (18) mittels einer Aussparungen aufweisenden Lochmaske auf der Oberseite (16) des Halbleitersubstrats (12),
- Implantieren eines oder mehrerer n-Dotierstoffe durch die Aussparungen der Lochmaske hindurch in das Kanalgebiet (18) zur Beeinflussung der Schwellspannung im Bereich zwischen -0,4 Volt und +0,5 Volt und
- thermisches Diffundieren der Dotierstoffe der durch die Aussparungen der Lochmaske in dem Kanalgebiet (18) eingebrachten Dotierstoffimplantationszonen zur Erzeugung einer im Wesentlichen homogenen oder einer uneinheitlichen Dotierstoffkonzentration in dem Kanalgebiet (18), wodurch die Schwellspannung im Bereich zwischen -0,4 Volt und +0,5 Volt bestimmt wird,
- Definieren von voneinander beabstandeten, p-dotierten Source- und Drain-Anschlussgebieten (24,26) an der Oberseite (16) des Halbleitersubstrats (12) innerhalb des Wannengebiets (14).

2. Verfahren nach Anspruch 1, ferner mit dem Schritt des Ausbildens zusätzlicher, elektrisch nicht leitender Bereiche innerhalb des Kanalgebiets (18), und zwar durch übliche Methoden zur Isolation von Bauelementen.

3. Verfahren nach Anspruch 1 oder 2, ferner mit den Schritten des Entfernens von Bereichen des Halbleitersubstrats (12) an dessen Oberseite (16), welche in der Nähe der Aussparungsränder enden, bis zu einer vorgebbaren Tiefe zur Ausbildung von Oberflächenvertiefungen (50), insbesondere durch lokales Ätzen, und des Auffüllens der Oberflächenvertiefungen (50) des Halbleitersubstrats (12), insbesondere durch Abscheiden, mit einem elektrisch isolierenden und/oder einem halbleitenden Füllmaterial (52), wobei optional das Halbleitersubstrat (12) nach dem Auffüllen der Oberflächenvertiefungen (50) an seiner Oberseite (16) chemisch und/oder mechanisch planarisiert wird.

4. Verfahren nach einem der Ansprüche 1 bis 3, **dadurch gekennzeichnet, dass** der Schritt des Implantierens des n-Dotierstoffs für die Beeinflussung der Schwellspannung eine Einfach- oder Mehrfach-, insbesondere Zweifach-Implantation mit unterschiedlichen n-Dotierstoffen umfasst.

5. Verfahren nach Anspruch 4, **dadurch gekennzeichnet, dass** die unterschiedlichen n-Dotierstoffe unterschiedlich tief in das Halbleitersubstrat (12) eindringen, wobei vorgesehen sein kann, dass der weniger tief eindringende n-Dotierstoff nach einem sich an die Mehrfach-Implantation anschließenden thermischen Behandlungsschritt in dem Halbleitersubstrat (12) weniger weit ausdiffundiert als der tiefer eindringende n-Dotierstoff.

6. Verfahren nach einem der Ansprüche 1 bis 5, **dadurch gekennzeichnet, dass** durch die Oberflächenvertiefungen (50) diejenigen Bereiche des Halbleitersubstrats (12), die in ihrer Oberflächendotierstoffkonzentration erhöht sind, ausgehoben werden und dadurch deren Oberflächendotierstoffkonzentration für die Bestimmung der Schwellspannung nicht wirksam sind.

7. Verfahren nach einem der Ansprüche 1 bis 6, **dadurch gekennzeichnet, dass** im Drain-Anschlussgebiet (26) und/oder zwischen dem Drain-Anschlussgebiet (26) und dem Kanalgebiet (18) zur Erhöhung der Spannungsfestigkeit eine Drift- bzw. Extensionszone (82) ausgebildet wird.

## Claims

1. Method for manufacturing a PMOS transistor having a low threshold voltage between -0.4 volts and +0.5 volts, comprising the following steps:
- providing a p-doped semiconductor substrate (12) with an upper side (16),
- generating an n-doped well region (14) by implanting an n-dopant through the upper side (16) of the semiconductor substrate (12) and into the latter,
- defining a channel region (18) on the upper side (16) of the semiconductor substrate (12) within the well region (14),
- masking the channel region (18) by means of a recessed shadow mask on the upper side (16) of the semiconductor substrate (12),
- implanting one or several n-dopants through the recesses of the shadow mask into the channel region (18) to affect the threshold voltage in the range between -0.4 volts and +0.5 volts, and
- thermal diffusing of the dopants of the dopant implantation zones introduced through the recesses of the shadow mask in the channel region (18) for generating a substantially homogenous or non-uniform dopant concentration in the channel region (18), whereby the threshold voltage is determined in the range between -0.4 volts and +0.5 volts,
- defining of spaced apart, p-doped source and drain junction regions (24, 26) on the upper side (16) of the semiconductor substrate (12) within the well region (14).

2. Method according to claim 1, further comprising the step of forming additional, electrically non-conductive regions within the channel region (18), namely by means of common methods for insulating components.

3. Method according to claim 1 or 2, further comprising the step of removing regions of the semiconductor substrate (12) on the upper side (16) thereof, which end in the vicinity of the recess edges, to a predeterminable depth to form surface indentations (50), in particular by local etching, and the step of filling the surface indentations (50) of the semiconductor substrate (12), in particular by deposition, with an electrically insulating and/or a semiconducting filling material (52), wherein the semiconductor substrate (12) is optionally planarized chemically and/or mechanically on its upper side (16) after the surface indentations (50) have been filled.

4. Method according to one of the claims 1 to 3, **characterized in that** the step of implanting the n-dopant for affecting the threshold voltage comprises a single or multiple implantation, in particular a double implantation, with various n-dopants.

5. Method according to claim 4, **characterized in that** the various n-dopants penetrate into the semiconductor substrate (12) to different depths, wherein it may be provided that the less deeply penetrating n-dopant, after a thermal treatment step following the multiple implantation, diffuses out less in the semiconductor substrate (12) than the more deeply penetrating n-dopant.

6. Method according to one of the claims 1 to 5, **characterized in that** the regions of the semiconductor substrate (12) having an increased surface dopant concentration are excavated through the surface indentations (50), and thus their surface dopant concentration is not effective for determining the threshold voltage.

7. Method according to one of the claims 1 to 6, **characterized in that** a drift zone respectively an extension zone (82) is adapted in the drain junction region (26) and/or between the drain junction region (26) and the channel region (18) to increase the voltage endurance.

## Revendications

1. Procédé de fabrication d'un transistor PMOS doté d'une tension de seuil réduite entre -0,4 Volt et +0,5 Volt, doté des étapes suivantes :
- préparation d'un substrat semi-conducteur dopé type P (12) avec une face supérieure (16),
- obtention d'un domaine de confinement dopé type N (14) par implantation d'un dopant N dans le substrat semi-conducteur (12) au travers de la face supérieure (16) de celui-ci,
- définition d'un domaine de canal (18) sur la face supérieure (16) du substrat semi-conducteur (12) au sein du domaine de confinement (14), masquage du domaine de canal (18) au moyen d'un masque perforé comportant des échancrures sur la face supérieure (16) du substrat semi-conducteur (12),
- implantation d'un ou plusieurs dopants de type N dans le domaine de canal (18) au travers des échancrures du masque perforé afin d'influer sur la tension de seuil dans un intervalle compris entre - 0,4 Volt et +0,5 Volt et
- diffusion thermique des dopants des zones d'implantation de dopant introduites dans le domaine de canal (18) au travers des échancrures du masque à trous pour obtention d'une concentration en dopant essentiellement homogène ou d'une concentration en dopant inégale dans le domaine de canal (18), déterminant ainsi la tension de seuil dans un intervalle compris entre -0,4 Volt et +0,5 Volt,
- définition de domaines de connexion de source et de drain (24, 26) dopés type P écartés l'un de l'autre sur la face supérieure (16) du substrat semi-conducteur (12) au sein du domaine de confinement (14).

2. Procédé selon la revendication 1, doté en outre de l'étape de réalisation au sein du domaine de canal (18) de zones supplémentaires électriquement non conductrices, et ainsi par des méthodes courantes pour l'isolation des composants.

3. Procédé selon la revendication 1 ou 2, doté en outre de l'étape d'élimination sur la face supérieure (16) du substrat semi-conducteur (12) des zones de celui-ci dont l'extrémité est proche des bords des échancrures, jusqu'à une profondeur pouvant être prédéfinie afin de réaliser des dépressions de surface (50), en particulier par corrosion localisée, et de l'étape de remplissage des dépressions de surface (50) du substrat semi-conducteur (12), en particulier par dépôt, avec un matériau de remplissage (52) électriquement isolant et/ou semi-conducteur, dans lequel, après le remplissage des dépressions de surface (50), le substrat semi-conducteur (12) est, en option, aplani chimiquement et/ou mécaniquement sur sa face supérieure (16).

4. Procédé selon l'une des revendications 1 à 3, **caractérisé en ce que** l'étape d'implantation du dopant N pour influer sur la tension de seuil comprend une implantation avec différents dopants N simple ou multiple, en particulier une implantation double.

5. Procédé selon la revendication 4, **caractérisé en ce que** les différents dopants N pénètrent dans le substrat semi-conducteur (12) à des profondeurs différentes, dans lequel il peut être prévu qu'après une étape de traitement thermique se rattachant à l'implantation multiple, le dopant N pénétrant moins profondément dans le substrat semi-conducteur (12) diffuse moins que le dopant N pénétrant plus profondément.

6. Procédé selon l'une des revendications 1 à 5, **caractérisé en ce que** chacune des zones du substrat semi-conducteur (12) ayant une concentration de surface en dopant élevée est creusée par les dépressions de surface (50) et ainsi dont les concentrations de surface en dopant ne sont pas déterminantes pour la tension de seuil.

7. Procédé selon l'une des revendications 1 à 6, **caractérisé en ce qu'**une zone de dérive ou d'extension (82) est réalisée dans le domaine de connexion de drain (26) et/ou entre le domaine de connexion de drain (26) et le domaine de canal (18) afin d'accroître la résistance au claquage.
